# EUROPEAN PATENT SPECIFICATION

(11) **EP 1 730 234 B1**
(45) Date of publication and mention of the grant of the patent: **21.07.2010**
(21) Application number: 05720439.8
(22) Date of filing: 03.03.2005
(51) Int. Cl.: C08L 67/00, C08L 23/00, C08L 23/08, C08L 67/02, C08L 67/03, C08L 67/04

(54) **RESIN MOLDED ARTICLE WITH REDUCED DIELECTRIC LOSS TANGENT AND PRODUCTION METHOD THEREFOR**
HARZFORMKÖRPER MIT VERRINGERTER DIELEKTRISCHER VERLUSTTANGENTE UND HERSTELLUNGSVERFAHREN DAFÜR
ARTICLE DE RÉSINE MOULÉ AVEC TANGENTE DE L'ANGLE DES PERTES DIÉLECTRIQUES ET SA MÉTHODE DE PRODUCTION

(30) Priority: 10.03.2004 JP 2004068009
(43) Date of publication of application: 13.12.2006
(73) Proprietor: Panasonic Electric Works Co., Ltd., Kadoma-shi Osaka (JP); Sumitomo Chemical Company, Limited, Tokyo 104-8260 (JP)
(72) Inventor: IKEGAWA, Naoto, Kadoma-shi, Osaka 571-8686 (JP); OKAMOTO, Satoshi, Kadoma-shi, Osaka 571-8686 (JP); KATAGIRI, Shiro, Kadoma-shi, Osaka 571-8686 (JP)
(74) Representative: Appelt, Christian W.
(86) International application number: PCT/JP2005/004168
(87) International publication number: WO 2005/085347

(56) References cited:
- EP-A- 0 407 129
- WO-A-95/15360
- US-A- 5 216 073

## Description

### TECHNICAL FIELD

The present invention relates to a resin molded article using a resin composition containing a liquid-crystalline polyester as the main component, which is preferably used in the field requiring radio-frequency properties, and a production method therefor.

### BACKGROUND ART

In the past, liquid-crystalline polyester that is excellent in electric properties and soldering heat resistance as well as chemical resistance, flame resistance and mechanical properties has been widely used as a material for electronic and mechanical parts. For example, since a circuit board obtained by forming a metal film on a resin substrate containing the liquid-crystalline polyester demonstrates good moldability, dimensional stability, high elastic modulus and strength, it also receives attention as a material for molded interconnect devices (MID).

As a circuit board using the liquid-crystalline polyester, for example, Japanese Patent Publication No. 2714440 discloses a circuit board obtained by molding a liquid-crystalline polyester resin composition to obtain a resin substrate, and then depositing a metal film on the resin substrate by means of sputtering, ion-plating or vacuum deposition, while heating the resin substrate in a vacuum chamber such that a surface temperature of the resin substrate is 60 °C or more. In addition, Japanese Patent Publication No. 7-24328 discloses a resin molded article for fine-line circuit, which is obtained by molding a resin composition containing a liquid-crystalline polyester and an inorganic filler to obtain a resin substrate, performing an etching treatment to roughen a surface of the resin substrate, and then depositing a metal film thereon by means of sputtering, ion-plating or vacuum deposition.

EP 0 407 129 A2 discloses a process for producing a moulding capable of forming a precision fine-line circuit by moulding a liquid-crystal polyester resin composition comprising a liquid-crystal polyester and an inorganic filler, forming flat plats thereof, etching it and then treating it to form a metallic coating on a surface.

By the way, when a circuit board obtained by molding a resin material is placed in an AC electric field, an amount of internal heat generation of the circuit board increases as the resin material has a larger dielectric loss tangent. The liquid-crystalline polyester has a relatively low dielectric loss tangent (tanδ) in conventional engineering plastics and super engineering plastics. However, in technical fields requiring high-frequency properties such as high-frequency circuit boards, it has been desired to develop a liquid-crystalline polyester based substrate having a further reduced dielectric loss tangent.

### SUMMARY OF THE INVENTION

Therefore, a primary concern of the present invention is to provide a resin molded article using a liquid-crystalline polyester based resin composition and having a reduced dielectric loss tangent.

This object is solved by a resin molded article according to claim 1 and a method for producing a resin molded article according to claim 7. Claims 2 to 6 refer to specifically advantageous embodiments of the resin molded article, claims 8 to 10 refer to specifically advantageous realizations of a method according to claim 8.

That is, the resin molded article of the present invention is obtained by performing a heat treatment to a resin composition after being molded comprising a liquid-crystalline polyester and an epoxy-group containing ethylene copolymer at a temperature lower than a flow-beginning temperature of the liquid-crystalline polyester, and characterized having a smaller dielectric loss tangent than the resin molded article obtained from the resin composition without the heat treatment.

It is preferred that the dielectric loss tangent of the resin molded article of the present invention is 90% or less of the dielectric loss tangent of the resin molded article obtained from the resin composition without the heat treatment. In addition, it is preferred to perform the heat treatment at a temperature between a lower limit temperature calculated by subtracting 120°C from the flow-beginning temperature of the liquid-crystalline polyester and an upper limit temperature calculated by subtracting 20°C from the flow-beginning temperature. Moreover, it is preferred that a content of the epoxy-group containing ethylene copolymer is in a range of 0.1 to 25 parts by weight with respect to 100 parts by weight of the liquid-crystalline polyester.

A further concern of the present invention is to provide a method of producing the resin molded article described above, which is characterized by comprising the steps of:
molding a resin composition comprising a liquid-crystalline polyester and an epoxy-group containing ethylene copolymer; and
performing a heat treatment to a resultant molded article at a temperature lower than a flow-beginning temperature of the liquid-crystalline polyester, preferably at a temperature between a lower limit temperature calculated by subtracting 120°C from the flow-beginning temperature and an upper limit temperature calculated by subtracting 20°C from the flow-beginning temperature, thereby obtaining the resin molded article having a smaller dielectric loss tangent than the resin molded article obtained from the resin composition without the heat treatment.

These and further purposes and advantages of the present invention will be clearly understood from the best mode for carrying out the invention described below.

### BEST MODE FOR CARRYING OUT THE INVENTION

As the liquid-crystalline polyester that is a main component of the resin composition constructing the resin molded article of the present invention, and preferably has an aromatic skeleton forming a molten phase with optical anisotropy, for example, it is preferred to use a reaction product obtained by an ester-exchange and polycondensation reaction of at least one of an aromatic dicarboxylic acid and an aromatic hydroxycarboxylic acid, with an acylated compound obtained by acylating a phenolic hydroxyl group of at least one of an aromatic diol and an aromatic hydroxycarboxylic acid with a fatty acid anhydride.

As the aromatic diol, for example, it is possible to use 4,4'-dihydroxybiphenyl, hydroquinone, resorcin, methyl hydroquinone, chloro hydroquinone, acetoxy hydroquinone, nitro hydroquinone, 1,4-dihydroxynaphthalene, 1,5-dihydroxynaphthalene, 1,6-dihydroxynaphthalene, 2,6-dihydroxynaphthalene, 2,7-dihydroxynaphthalene, 2,2-bis(4-hydroxyphenyl) propane, 2,2-bis(4-hydroxy-3,5-dimethylphenyl) propane, 2,2-bis(4-hydroxy-3,5-dichlorophenyl) propane, 2,2-bis(4-hydroxy-3-methylphenyl) propane, 2,2-bis(4-hydroxy-3-chlorophenyl) propane, bis(4-hydroxyphenyl)methane, bis(4-hydroxy-3,5-dimethylphenyl)methane, bis(4-hydroxy-3,5-dichlorophenyl)methane, bis(4-hydroxy-3, 5-dibromophenyl)methane, bis(4-hydroxy-3-methylphenyl)methane, bis(4-hydroxy-3-chlorophenyl)methane, 1,1-bis(4-hydroxyphenyl)cyclohexane, bis(4-hydroxyphenyl)ketone, bis(4-hydroxy-3,5-dimethylphenyl)ketone, bis(4-hydroxy-3,5-dichlorophenyl)ketone, bis(4-hydroxyphenyl) sulfide, or bis(4-hydroxyphenyl) sulfone. One of these compounds may be used by itself, or a combination of two or more of these compounds may be used as the aromatic diol. In particular, from the viewpoint of ready availability, it is preferred to use 4,4'-dihydroxybiphenyl, hydroquinone, resorcin, 2,6-dihydroxynaphthalene, 2,2-bis(4-hydroxyphenyl) propane or bis(4-hydroxyphenyl) sulfone.

On the other hand, as the aromatic hydroxycarboxylic acid, for example, it is possible to use parahydroxy benzoic acid, metahydroxy benzoic acid, 2-hydroxy-6-naphthoic acid, 2-hydroxy-3-naphthoic acid, 1-hydroxy-4-naphthoic acid, 4-hydroxy-4'-carboxydiphenyl ether, 2,6-dichloro-parahydroxy benzoic acid, 2-chloro-parahydroxy benzoic acid, 2,6-difluoro-parahydroxy benzoic acid, or 4-hydroxy-4'-biphenylcarboxylic acid. One of these compounds may be used by itself, or a combination of two or more of these compounds may be used as the aromatic hydroxycarboxylic acid. In particular, from the viewpoint of ready availability, it is preferred to use parahydroxy benzoic acid or 2-hydroxy-6-naphthoic acid.

In addition, as the aromatic dicarboxylic acid, for example, it is possible to use terephthalic acid, isophthalic acid, 2,6-naphthalene dicarboxylic acid, 1,5-naphthalene dicarboxylic acid, 4,4'-biphenyldicarboxylic acid, methyl terephthalate, methyl isophthalate, diphenylether-4,4'-dicarboxylic acid, diphenylsulfone-4,4'-dicarboxylic acid, diphenylketone-4,4'-dicarboxylic acid, or 2,2'-diphenylpropane-4,4'dicarboxylic acid. One of these compounds may be used by itself, or a combination of two or more of these compounds may be used as the aromatic dicarboxylic acid. In particular, from the viewpoint of ready availability, it is preferred to use terephthalic acid, isophthalic acid or 2,6-naphthalene dicarboxylic acid.

As the fatty acid anhydride, for example, it is possible to use acetic anhydride, propionic anhydride, butyric anhydride, isobutylic anhydride, valeric anhydride, pivalic anhydride, 2-ethylhexanoic anhydride, monochloroacetic anhydride, dichloroacetic anhydride, trichloroacetic anhydride, monobromoacetic anhydride, dibromoacetic anhydride, tribromoacetic anhydride, monofluoroacetic anhydride, difluoroacetic anhydride, trifluoroacetic anhydride, glutaric anhydride, maleic anhydride, succinic anhydride or β-bromopropionic anhydride. One of these compounds may be used by itself, or a combination of two or more of these compounds may be used as the fatty acid anhydride. In particular, from the viewpoints of cost performance and ease of handling; it is preferred to use acetic anhydride, propionic anhydride, butyric anhydride, or isobutylic anhydride, and particularly acetic anhydride.

It is preferred that the ester-exchange and polycondensation reaction is performed in the presence of an imidazole compound represented by the following chemical formula (1). 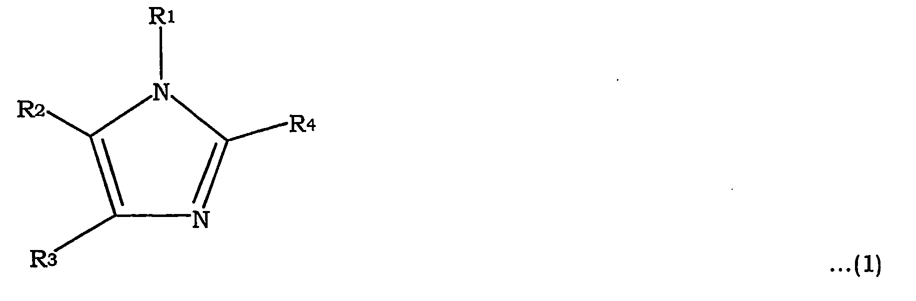 (In the formula (1), each of "R₁" to "R₄" is selected from hydrogen atom, alkyl group having a carbon number of 1 to 4, hydroxymethyl group, cyano group, cyanoalkyl group having a carbon number of 1 to 4, cyanoalkoxy group having a carbon number of 1 to 4, carboxyl group, amino group, aminoalkyl group having a carbon number of 1 to 4, aminoalkoxy group having a carbon number of 1 to 4, phenyl group, benzyl group, phenylpropyl group, and a formyl group.)

As the imidazole compound represented by the formula (1), for example, it is possible to use imidazole, 1-methylimidazole, 2-methylimidazole, 4-methylimidazole, 1-ethylimidazole, 2-ethylimidazole, 4-ethylimidazole, 1,2-dimethylimidazole, 1,4-dimethylimidazole, 2,4-dimethylimidazole, 1-methyl-2-ethylimidazole, 1-methyl-4-ethylimidazole, 1-ethyl-2-methyhmidazole, 1-ethyl-2-ethylimidazole, 1-ethyl-2-phenylimidazole, 2-ethyl-4-methylimidazole, 2-phenylimidazole, 2-undecylimidazole, 2-heptadecylimidazole, 1-benzyl-2-methylimidazole, 2-phenyl-4-methylimidazole, 1-cyanoethyl-2-methylimidazole, 1-cyanoethyl-2-phenylimidazole, 4-cyanoethyl-2-ethyl-4-methylimidazole or 1-aminoethyl-2-methylimidazole. In a particularly preferred imidazole compound, "R₁" is an alkyl group having a carbon number of 1 to 4, and "R₂" to "R₄" are hydrogen atoms. In addition, from the viewpoint of ready availability, it is preferred to use 1-methylimidazole or 2-methylimidazole.

In the above ester-exchange and polycondensation reaction, it is preferred that amounts of the acylated compound and the aromatic dicarboxylic acid and/or the aromatic hydroxycarboxylic acid are determined such that an amount of the phenolic hydroxyl group of the aromatic diol and/or the aromatic hydroxycarboxylic acid used to prepare the acylated compound is in a range of 0.8 to 1.2 in terms of equivalent number of hydroxy group relative to carboxyl group of the aromatic dicarboxylic acid and/or the aromatic hydroxycarboxylic acid. In addition, it is preferred to proceed the ester-exchange reaction in a temperature range of from 130 °C to 400 °C, while elevating the temperature at a ratio of 0.1 to 50 °C/min, and more preferably in a temperature range of from 150 °C to 350 °C, while elevating the temperature at a ratio of 0.3 to 5 °C/min.

As the acylated compound, it is possible to use a product obtained by acylating the phenolic hydroxyl group with the fatty acid anhydride in a reaction vessel, or a compound having an acylated phenolic hydroxyl group, i.e., an fatty acid ester. It is preferred that an amount of the fatty acid anhydride is in a range of 1.0 to 1.2 and more preferably 1.05 to 1.1 in terms of equivalent number of the phenolic hydroxyl group of the aromatic diol and/or the aromatic hydroxycarboxylic acid. When the amount of the fatty acid anhydride is less than 1.0 in terms of equivalent number of the phenolic hydroxyl group, sublimation of the raw material may be caused at the time of polycondensation of the liquid-crystalline polyester due to a shift of equilibrium toward the fatty acid anhydride at the time of acylation. In this case, the reaction system is easily clogged. On the other hand, when the amount of the fatty acid anhydride exceeds 1.2 in terms of equivalent number of the phenolic hydroxyl group, a coloration of the obtained liquid-crystalline polyester may become a problem. In addition, it is preferred that the acylation is performed at a temperature of 130 to 180 °C for 30 minutes to 20 hours, and more preferably 140 to 160 °C for 1 to 5 hours.

To facilitate the ester-exchange reaction between the fatty acid ester and carboxylic acid through the use of a shift of equilibrium, it is preferred that by-product fatty acid and unreacted fatty acid anhydride are vaporized and removed from the reaction system. In addition, when a part of vaporized (or distilled) fatty acid is allowed to reflux in the reaction vessel, vaporized or sublimed raw material component can be returned into the reaction vessel together with the refluxed fatty acid by phenomenon of condensation or reverse sublimation.

In the ester-exchange and polycondensation reaction, it is preferred that an additive amount of the imidazole compound represented by the formula (1) is in a range of 0.005 to 1 parts by weight with respect to 100 parts by weight of a total of the aromatic dicarboxylic acid, aromatic diol, and the aromatic hydroxycarboxylic acid used to synthesize the liquid-crystalline polyester. From the viewpoints of color tone and productivity of the liquid-crystalline polyester, it is more preferred that the additive amount of the imidazole compound is in a range of 0.05 to 0.5 parts by weight. When the additive amount is less than 0.005 parts by weight, a contribution of the imidazole compound to the acceleration of the ester-exchange and polycondensation reaction is not obtained sufficiently. On the other hand, when the additive amount exceeds 1 part by weight, it may be difficult to control the reaction system. The timing of adding the imidazole compound is not restricted on condition that the imidazole compound at least exists in the reaction system at the time of ester-exchange. Therefore, the imidazole compound may be added immediately before the ester-exchange and polycondensation reaction or in process of the reaction.

To accelerate the ester-exchange and polycondensation reaction, if necessary, a catalyst may be used. For example, the catalyst comprises a germanium compound such as germanium oxide, tin compound such as stannous oxalate, stannous acetate, dialkyl tin oxide and diaryl tin oxide, titanium compound such as titanium dioxide, titanium alkoxide and alkoxy titanium silicate, antimony compound such as antimony trioxide, metal salt of organic acid such as sodium acetate, potassium acetate, calcium acetate, zinc acetate and ferrous acetate, Lewis acid such as boron trifluoride and aluminum chloride, amines, amides, and an inorganic acid such as hydrochloric acid and sulfuric acid.

The liquid-crystalline polyester of the present invention prepared by the ester-exchange and polycondensation reaction described above has the aromatic skeleton forming the molten phase with optical anisotropy. To allow the liquid-crystalline polyester to have heat resistance and impact resistance in a balanced manner, it is preferred that the liquid-crystalline polyester contains at least 30 mol% of a repeating unit represented by the following chemical formula (2). In addition, there is no limitation in molecular weight of the liquid-crystalline polyester. For example, it is preferred that a weight-average molecular weight of the liquid-crystalline polyester is in a range of 10000 to 50000.

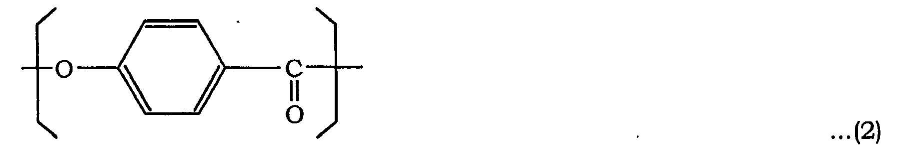

In addition, it is preferred that the repeating unit contained in the liquid-crystalline polyester is selected from the following combinations (a) to (f) based on the aromatic hydroxy carboxylic acid, aromatic dicarboxylic acid and the aromatic diol.
(a) a combination of a structural unit based on 2-hydroxy-6-naphthoic acid, structural unit based on 2,6-naphthalene dicarboxylic acid or a mixture of 2,6-naphthalene dicarboxylic acid and terephthalic acid, and a structural unit based on 4,4'-dihydroxybiphenyl
(b) a combination obtained by replacing a part or all of the structural unit based on 4,4'-dihydroxybiphenyl in the combination (a) with a structural unit based on hydroquinone
(c) a combination obtained by replacing a part or all of the structural unit based on 4,4'-dihydroxybiphenyl in the combination (a) with a structural unit based on 2,6-dihydroxynaphthalene
(d) a combination obtained by replacing a part or all of the structural unit based on 2,6-naphthalene dicarboxylic acid in the combination (a) with a structural unit based on isophthalic acid
(e) a combination obtained by replacing a part or all of the structural unit based on 2,6-naphthalene dicarboxylic acid in the combination (a) with a structural unit based on a mixture of terephthalic acid and isophthalic acid
(f) a combination obtained by replacing a part or all of the structural unit based on 2-hydroxy-6-naphthoic acid in the combination (a) with a structural unit based on parahydroxy benzoic acid

In the combinations (a) to (f), it is preferred that the liquid-crystalline polyester contains 30 to 80 mol% of a repeating unit derived from 2-hydroxy-6-naphthoic acid, 10 to 35 mol% of a repeating unit derived from the aromatic diol, and 10 to 35 mol% of a repeating unit derived from the aromatic dicarboxylic acid. In this case, it is possible to obtain a higher effect of reducing the dielectric loss tangent as well as excellent properties of the liquid-crystalline resin.

Next, the epoxy-group containing ethylene copolymer is explained, which is an important component of the resin composition constructing the resin molded article of the present invention. In the present invention, it is preferred that the epoxy-group containing ethylene copolymer contains 80 to 95 wt% of an ethylene unit and 5 to 15 wt% of at least one of an unsaturated carboxylic-acid glycidyl ester unit and an unsaturated glycidyl ether unit in the molecule thereof. When the amount of the ethylene unit is less than 80 wt%, heat resistance and toughness of the resin substrate may deteriorate. In addition, as described later, when a molded circuit board is produced by forming a metal film on the resin molded article of the present invention, it is preferred that the amount of at least one of the unsaturated carboxylic-acid glycidyl ester unit and the unsaturated glycidyl ether unit is 5 wt% or more to improve the adhesion of the metal film. In addition to these units, if necessary, the epoxy-group containing ethylene copolymer may contain an ethylenically unsaturated ester unit. In this case, it is preferred that an amount of the ethylenically unsaturated ester unit is 50 wt% or less.

For example, compounds imparting the unsaturated carboxylic-acid glycidyl ester unit or the unsaturated glycidyl ether unit are represented by the following chemical formulas (3) and (4). 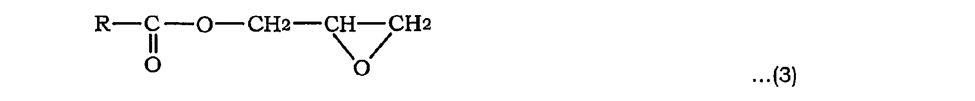 ("R" is a hydrocarbon group having a carbon number of 2 to 13 and an ethylenically unsaturated bond.) 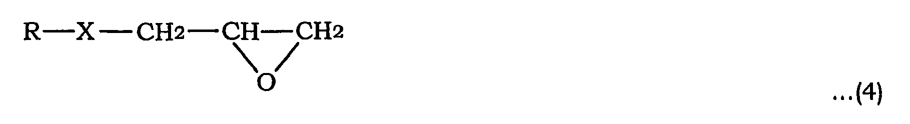 ("R" is a hydrocarbon group having a carbon number of 2 to 13 and an ethylenically unsaturated bond, and "X" is

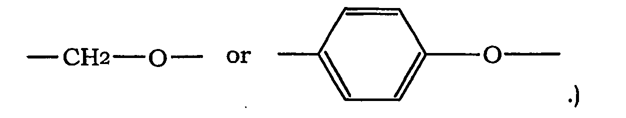

Specifically, it is possible to use glycidyl acrylate, glycidyl methacrylate, glycidyl ester of itaconic acid, allyl glycidyl ether, 2-methyl allyl glycidyl ether, or styrene-p-glycidyl ether, or the like.

As the epoxy-group containing ethylene copolymer, a ternary or more copolymer may be used, which contains an ethylenically unsaturated ester in addition to ethylene, and the unsaturated carboxylic-acid glycidyl ester and/or the unsaturated glycidyl ether. As such an ethylenically unsaturated ester compound, for example, it is possible to use a carboxylic acid vinyl ester such as vinyl acetate, vinyl propionate, methyl acrylate, ethyl acrylate, butyl acrylate, methyl methacrylate, ethyl methacrylate and butyl methacrylate, or α,β-unsaturated carboxylic acid alkyl ester. In particular, it is preferred to use vinyl acetate, methyl acrylate or ethyl acrylate.

The epoxy-group containing ethylene copolymer can be prepared by performing a copolymerization of a compound imparting the ethylene unit, compound of imparting the unsaturated carboxylic-acid glycidyl ester unit or the unsaturated glycidyl ether unit, and if necessary a compound imparting the ethylenically unsaturated ester unit under conditions of a pressure of 500 to 4000 atm and a temperature of 100 to 300 °C in the presence of a radical generating agent. If necessary, the copolymerization may be performed in the presence of an appropriate solvent or a chain transfer agent.

Specifically, as the epoxy-group containing ethylene copolymer, for example, it is possible to use a copolymer comprised of the ethylene unit and a glycidyl methacrylate unit, copolymer comprised of the ethylene unit, glycidyl methacrylate unit and a glycidyl methyl acrylate unit, copolymer comprised of the ethylene unit, glycidyl methacrylate unit and a glycidyl ethyl acrylate unit, or a copolymer comprised of the ethylene unit, glycidyl methacrylate unit and a vinyl acetate unit. In particular, it is preferred to use the copolymer comprised of the ethylene unit and the glycidyl methacrylate unit.

In addition, it is preferred that the epoxy-group containing ethylene copolymer has an melt index (MFR: JIS K7210, measuring conditions: 190 °C, 2.16 kg load) of 0.5 to 100 g/10 min, and more preferably 2 to 50 g/10 min. In this range, there is an advantage that good mechanical properties of the resin substrate and compatibility with the liquid-crystalline polyester are obtained.

In the resin molded article of the present invention, it is preferred that a content of the epoxy-group containing ethylene copolymer is in a range of 0.1 to 25 parts by weight, and more preferably 10 to 20 parts by weight with respect to 100 parts by weight of the liquid-crystalline polyester. In this range, the heat-treatment effect of reducing the dielectric loss tangent becomes higher. When the content is less than 0.1 parts by weight, it may difficult to use the resin molded article of the invention as a circuit board because the adhesion of a metal film for circuit pattern formed thereon easily deteriorate On the other hand, when the content is more than 25 parts by weight, heat resistance and moldability of the resin composition may deteriorate.

To reinforce the resin substrate, if necessary, an inorganic filler may be added to the resin composition. The kind of the inorganic filler is not restricted. For example, as the inorganic filler, a fiber-like inorganic filler, whisker, plate-like inorganic filler or a powder-like inorganic filler can be added to the resin composition.

The resin molded article of the present invention can be obtained by molding the resin composition containing the above-described liquid-crystalline polyester, epoxy-group containing ethylene copolymer and if necessary the inorganic filler, and then performing a heat treatment to a resultant molded article at a temperature lower than a flow-beginning temperature of the liquid-crystalline polyester. The thus heat-treated resin molded articled has a smaller dielectric loss tangent than the resin molded article obtained from the same resin composition without the heat treatment.

It is preferred to perform the heat treatment at a temperature between a lower limit temperature calculated by subtracting 120°C from the flow-beginning temperature of the liquid-crystalline polyester, and an upper limit temperature calculated by subtracting 20°C from the flow-beginning temperature. The flow-beginning temperature is defined as a temperature showing a melting viscosity of 48000 poise when a molten material is extruded through a nozzle under conditions of a load of 100 kgf/cm² (980 N/cm²) and a heating rate of 4 °C/min by use of a capillary rheometer with the nozzle having an inner diameter of 1 mm and a length of 10 mm. The relevant standard in Japanese Industrial Standards (JIS) is K6719-1977. When the temperature is less than the lower limit temperature, the effect of the heat treatment is not obtained sufficiently. On the other hand, when the temperature is more than the upper limit temperature, a warpage or a deformation of the resin substrate may occur. It is also preferred to perform the heat treatment in an inert-gas atmosphere such as nitrogen gas under a condition that the residual oxygen concentration is less than 1 %, preferably less than 0.5 %. In addition, from the viewpoint of preventing a denaturation of the resin substrate, it is preferred that the heat treatment time is in a range of 1 to 4 hours.

According to the heat treatment described above, the heat resistance of the resin substrate can be also improved in addition to the improvement in electric properties such as RF properties resulting from the decrement in dielectric loss tangent. Moreover, in the case of using the resin molded article of the invention as the circuit board, it is possible to improve the adhesion of the metal film formed thereon. Of course, the resin moulded article of the present invention stably maintains the original excellent properties of the liquid-crystalline polyester such as chemical resistance, low linear expansion coefficient, flame resistance, high mechanical strength, electrical insulation, high damping property and elastic modulus. Therefore, the resin molded article of the present invention will be preferably used as, for example, an antenna, wave guide tube, or a substrate for optical transmission other than the circuit board.

As an example, a method of producing the circuit board by forming the metal film on a resin substrate provided by the resin molded article of the present invention is introduced below.

Prior to the formation of the metal film, it is preferred to perform a plasma treatment to the surface of the heat-treated resin substrate. Since the epoxy-group containing ethylene copolymer in the resin composition possesses a high reactive functional group, the surface of the resin substrate can be effectively activated by the plasma treatment. Therefore, an effect of the plasma treatment on the adhesion of the metal film is extremely high.

The plasma treatment can be performed by using a conventional plasma treatment apparatus. For example, a plasma treatment apparatus comprising a pair of electrodes disposed in a face-to-face relation in a chamber, and a RF unit for applying a RF electric field between the electrodes can be used. In this case, the resin substrate is placed on one of the electrodes, and the chamber is depressurized to approximately 10⁻⁴ Pa. Then, a plasma forming gas such as NH₃ and N₂ is introduced in the chamber such that the inner pressure becomes in a range of 8 to 15 Pa. Next, an RF power (13.56 MHz) of 300 W is applied between the electrodes for a time period of 10 to 100 seconds by use of the RF unit to generate a plasma therebetween, so that the surface of the resin substrate is activated by cations and radicals in the generated plasma. Since a nitrogen polar group or an oxygen polar group, which has the capability of easily bonding with metal, is imparted to the surface of the resin substrate by the collision with the cations during the plasma treatment, the adhesion of the metal film can be further improved.

The plasma treatment conditions can be arbitrarily determined on the assumption that the surface of the resin substrate is not excessively roughened by the plasma treatment. In addition, the kind of a plasma forming gas is not restricted. For example, as described above, it is preferred to use nitrogen as the plasma forming gas. In the case of using the nitrogen plasma, it is possible to reduce a desorption of carbon dioxide gas resulting from a breakage of the ester bonding of the resin substrate, as compared with the case of using an oxygen plasma. Consequently, it is possible to avoid a reduction in strength of a surface portion of the resin substrate.

To form the metal film, it is preferred to use a physical vapor deposition such as sputtering, vacuum deposition and ion plating. In the case of performing the plasma treatment described above, it is preferred that the film formation is continuously carried out without exposing the resin substrate to air. A metal material constructing the metal film is not restricted. For example, it is possible to select from the group essentially consisting of copper, nickel, gold, aluminum, titanium, molybdenum, chromium, tungsten, tin, lead, brass, Nichrome and an alloy thereof.

In the case of using a DC sputtering method as the sputtering, for example, the chamber having the resin substrate therein is depressurized to less than 10⁻⁴ Pa, and then an inert gas such as Ar is introduced in the chamber such that the inner pressure becomes approximately 0.1 Pa. Next, a DC voltage of 500 V is applied to bombard a copper target, so that a copper film having a thickness of 200 to 500 nm can be formed as the metal film on the resin substrate.

In the case of using an electron-beam vacuum deposition method as the vacuum deposition, for example, the chamber having the resin substrate therein is depressurized to less than 10⁻⁴ Pa. Then, an electron flow of 400 to 800 mA is allowed to collide with a metal material in a crucible, thereby evaporating the metal material. Consequently, a copper film having a thickness of approximately 300 nm can be formed as the metal film on the resin substrate.

In the case of using the ion plating, for example, the chamber having the resin substrate therein is depressurized to less than 10⁻⁴ Pa, and then the metal material is vaporized, as in the case of the vacuum deposition. In addition, an inert gas such as Ar is introduced between the resin substrate and a crucible such that the inner pressure becomes in a range of 0.05 to 0.1 Pa. Next, a RF power (13.56 MHz) of 500 W is applied to an induced antenna under a condition that a desired bias voltage is applied to the electrode, by which the resin substrate is supported, thereby generating a plasma in the chamber. Consequently, a copper film having a thickness of 200 to 500 nm can be formed as the metal film on the resin substrate.

Next, a circuit pattern is formed in the metal film on the resin substrate. For example, it is recommended to use laser patterning from the viewpoint of efficiently removing unwanted metal film other than circuit portions without deteriorating the adhesion of the metal film. According to the present invention, since it is not needed to perform a roughening treatment for improving the adhesion of the metal film prior to the film formation, it is possible to form a fine circuit pattern with accuracy by the laser patterning without a deterioration in wiring accuracy resulting from the formation of the metal film on the roughened surface of the resin substrate. Therefore, the resin molded article of the present invention is also suitable for Molded Interconnect Devices (MID).

After the laser patterning, an additional metal film such as copper may be formed on the formed circuit pattern of the metal film by electrolytic plating such that the total thickness becomes in a range of, for example, 5 to 20 µm. After the formation of the circuit pattern, a soft etching may be performed to surely remove unwanted metal film remaining on the resin substrate, if necessary. In addition, a nickel plating layer or a gold plating layer having a thickness of several microns may be formed on the additional metal film. Thus, the molded circuit board having a desired circuit pattern thereon can be obtained by use of the resin molded article of the present invention.

### EXAMPLES

The present invention is concretely explained according to preferred Examples.

### (Synthesis of Liquid-crystalline Polyester "S1")

911 g (6.6 mol) of p-hydroxybenzoic acid, 409 g (2.2 mol) of 4,4'-dihydroxybiphenyl, 274 g (1.65 mol) of terephthalic acid, 91 g (0.55 mol) of isophthalic acid, 1235 g (12.1 mol) of acetic anhydride, and 0.17 g of 1-methylimidazole were put in a reaction vessel having an agitator , torque meter, nitrogen introduction pipe, temperature gauge and a reflux condenser, and then the air in the reaction vessel was replaced by nitrogen gas. Next, the temperature of a resultant mixture was raised to 150 °C by 15 minutes under a nitrogen gas flow, and refluxed for 3 hours at 150 °C.

Subsequently, 1.69 g of 1-methylimidazole was further added to the mixture, and then the obtained mixture was heated from 150 °C to 320 °C by 170 minutes, while by-product acetic acid and unreacted acetic anhydride were being vaporized and removed therefrom. When an increase in torque occurred, it was regarded as the end of the reaction, and a resultant product was removed out from the reaction vessel. The solid content of the resultant product was cooled at room temperature, and crushed by a coarse grinder. Next, the obtained powder was heated from room temperature to 250 °C by 1 hour under a nitrogen atmosphere. In addition, it was heated from 250 °C to 288 °C by 5 hours, and then kept at 288 °C for 3 hours to promote solid-phase polymerization reaction. Thus, the liquid-crystalline polyester "S1" was obtained. A flow-beginning temperature of this liquid-crystalline polyester measured by use of a flow tester ("CFT-500" manufactured by Shimadzu Corporation) is 320 °C.

### (Synthesis of Liquid-crystalline Polyester "S2")

752.72 g (4.00 mol) of 2-hydroxy-6-naphthoic acid, 220.22 g (2.00 mol) of hydroquinone, 432.38 g (2.00 mol) of 2,6-naphthalene dicarboxylic acid, and 986.19 g (9.2 mol) of acetic anhydride were put in a reaction vessel having an agitator, torque meter, nitrogen introduction pipe, temperature gauge and a reflux condenser, and then 0.143 g of 1-methylimidazole was also added as a catalyst. A resultant mixture was agitated at room temperature for 15 minutes, and then heated at 145 °C, while being agitated. As this temperature, the mixture was further agitated for 1 hour.

Subsequently, the resultant mixture was heated from 145 °C to 310 °C by 3 hours, while by-product acetic acid and unreacted acetic anhydride were being vaporized and removed therefrom. After 1.427 g of 1-methylimidazole was further added, the mixture was kept for 30 minutes at 310 °C to obtain an aromatic polyester. The obtained aromatic polyester was cooled at room temperature, and crushed by a coarse grinder to obtain an aromatic polyester powder (particle size: approximately 0.1 mm to 1 mm).

After the obtained powder was heated from 25 °C to 250 °C by 1 hour, it was further heated from 250 °C to 320 °C by 5 hours, and kept at 320 °C for 3 hours to promote solid-phase polymerization reaction. Thus, the liquid-crystalline polyester "S2" was obtained. A flow-beginning temperature of this liquid-crystalline polyester measured by using the flow tester "CFT-500" is 333 °C.

On the other hand, as the epoxy-group containing ethylene cop olymer, Bond First® "BF-E", "BF-2C", "BF-7M" and "BF-2B" (manufactured by SUMITOMO CHEMICAL Co., Ltd.) were used. The Bond First® "BF-E" is an ethylene-glycidyl methacrylate copolymer (the content of glycidyl methacrylate: 12 wt%, MFR = 3 g/10 minutes). The Bond First® "BF-2C" is an ethylene-glycidyl methacrylate copolymer (the content of glycidyl methacrylate: 6 wt%, MFR = 3 g/10 minutes). The Bond First® "BF-7M" is an ethylene-glycidyl methacrylate-methyl acrylate copolymer (the content of glycidyl methacrylate: 6 wt%, the content of methyl acrylate: 30 wt%, MFR = 9 g/10 minutes). The Bond First® "BF-2B" is an ethylene-glycidyl methacrylate-vinyl acetate copolymer (the content of glycidyl methacrylate: 12 wt%, the content of vinyl acetate: 5 wt%, MFR = 3 g/10 minutes). The MFR (Melt Flow Rate) value was measured at the temperature of 190 °C under the load of 2160 g according to JIS(Japanese Industrial Standards) K7210.

If necessary, as an inorganic filler, a milled glass fiber (MGF: "EFH-7501" manufacture by CENTRAL GLASS CO., LTD., fiber diameter: 10µm, aspect ratio: 10), barium titanate powder ("NPO-S" manufactured by FUJI TITANIUM INDUSTRY CO.,LTD., average particle size: 2.1 µm) or a strontium titanate powder ("ST-1" manufactured by FUJI TITANIUM INDUSTRY CO.,LTD., average particle size: 1.1 µm) was used.

### (Example 1)

100 parts by weight of the liquid-crystalline polyester "S1" was mixed with 10 parts by weight of the epoxy-group containing ethylene copolymer "BF-E" and 100 parts by weight of the barium titanate powder "NPO-S" as the inorganic filler to obtain a resin composition. Then, pellets of the resin composition were prepared at 340 °C by using a twin Screw Extruder ("PCM-30" manufactured by Ikegai Tekko). The prepared pellets were injection molded at a cylinder temperature of 350 °C and a mold temperature of 130 °C by using an injection molding machine ("PS40E5ASE" manufactured by Nissei Plastic Industrial Co., Ltd.), thereby obtaining a resin substrate having the dimensions of 40 mm x 30 mm x lmm.

Next, a heat treatment was performed to the resin substrate at 300 °C for 3 hours in a nitrogen atmosphere. Then, a plasma treatment was performed to a surface of the resin substrate. That is, the resin substrate was placed in a chamber of plasma treatment apparatus, and then the chamber was evacuated to approximately 10⁻⁴ Pa. In addition, nitrogen gas was introduced into the chamber such that the gas pressure in the chamber is 10 Pa, and then the plasma treatment was performed to the resin substrate by applying a RF power voltage (13.56 MHz) of 300 W between electrodes of the plasma treatment apparatus for 30 seconds. After the plasma treatment, a metal film was formed on the plasma-treated surface of the resin substrate by using a DC magnetron sputtering apparatus. That is, after the chamber was evacuated to less than 10⁻⁴ Pa, argon gas was introduced into the chamber such that the gas pressure in the chamber is 0.1 Pa, and then a copper target was bombarded by applying a DC voltage of 500 V to form a copper film having the thickness of 400 nm as the metal film on the resin substrate.

Next, a pattern having the width of 5 mm was formed in the metal film by laser irradiation, and copper was plated on the pattern of the metal film by electrolytic plating to obtain a circuit pattern for peel strength test having the thickness of 15 µm on the resin substrate.

### (Examples 2 to 4)

In each of Examples 2 to 4, a resin substrate having the circuit pattern for peel strength test was produced according to a substantially same method as Example 1 except for using a different amount of the epoxy-group containing ethylene copolymer "BF-E", as listed in Table 1.

### (Comparative Example 1)

A resin substrate having the circuit pattern for peel strength test was produced according to a substantially same method as Example 1 except that the epoxy-group containing ethylene copolymer was not added, and the heat treatment was not performed.

### (Comparative Example 2)

A resin substrate having the circuit pattern for peel strength test was produced according to a substantially same method as Example 1 except that the heat treatment was not performed.

### (Comparative Example 3)

A resin substrate having the circuit pattern for peel strength test was produced according to a substantially same method as Example 1 except that an additive amount of the epoxy-group containing ethylene copolymer "BF-E" is 24 parts by weight, and the heat treatment was not performed.

**TABLE 1**

| | Examples | | | | Comparative Examples | | |
|---|---|---|---|---|---|---|---|
| | 1 | 2 | 3 | 4 | 1 | 2 | 3 |
| Liquid Crystalline Polyester | S 1 | S 1 | S 1 | S 1 | S 1 | S 1 | S 1 |
| (parts by weight) | 100 | 100 | 100 | 100 | 100 | 100 | 100 |
| Epoxy-group-containing | BF-E | BF-E | BF-E | BF-E | None | BF-E | BF-E |
| Ethylene Copolymer (parts by weight) | 10 | 16 | 20 | 24 | | 10 | 24 |
| Inorganic Filler (NPO-S) | 100 | 100 | 100 | 100 | 100 | 100 | 100 |
| (parts by weight) | | | | | | | |
| Heat Treatment Conditions | 300°C, | 300°C, | 300°C, | 300°C, | None | None | None |
| | 3hrs, N₂ | 3hrs, N₂ | 3hrs, N₂ | 3hrs, N₂ | | | |
| Dielectric Loss tan δ (x 10⁻³) | 3.97 | 3.88 | 3.80 | 3.74 | 4.50 | 5.14 | 6.23 |
| Peel Strength (N/mm) | 0.35 | 0.37 | 0.40 | 0.41 | 0.29 | 0.31 | 0.35 |

With respect to each of Examples 1 to 4 and Comparative Examples 1 to 3, dielectric loss tangent (tan δ) of the resin substrate and 90 degree peel strength of the circuit pattern were measured. That is, the dielectric loss tangent (tan δ) was determined at 1 GHz by performing an impedance measurement according to an RF I-V method by use of a RF impedance/material analyzer "HP 4291A". The peel strength was measured by using a universal testing machine ("EG Test" manufactured by Shimadzu Corporation). Results are shown in Table 1.

As understood from a comparison between Example 1 and Comparative Example 2 using the resin substrate having the same composition as Example 1, the dielectric loss tangent was remarkably reduced by the heat treatment. That is, the dielectric loss tangent of the heat-treated resin substrate of Example 1 corresponds to approximately 77 % of the dielectric loss tangent of the resin substrate of Comparative Example 2 without the heat treatment. Similarly, from the results of Example 4 and Comparative Example 3 using the resin substrate having the same composition as Example 4, the dielectric loss tangent of the heat-treated resin substrate of Example 4 corresponds to approximately 60 % of the dielectric loss tangent of the resin substrate of Comparative Example 3 without the heat treatment. In addition, with respect to comparative Examples 1 to 3 without the heat treatment, as larger the content of the epoxy-group containing ethylene copolymer, the dielectric loss tangent increases. On the contrary, with respect to Examples 1 to 4 with the heat treatment of the present invention, as larger the content of the epoxy-group containing ethylene copolymer, the dielectric loss tangent decreases. Thus, the heat treatment of the present invention presents a remarkable effect of reducing the dielectric loss tangent in the case that the liquid-crystalline polyester based resin substrate contains the epoxy-group containing ethylene copolymer. Furthermore, the comparisons between Examples 1, 4 and Comparative Examples 2, 3 show that the heat treatment is also effective to improve the adhesion of the circuit pattern.

### (Example 5)

A resin substrate having the circuit pattern for peel strength test was produced according to a substantially same method as Example 1 except that 100 parts by weight of the liquid-crystalline polyester "S1" was mixed with 15 parts by weight of the epoxy-group containing ethylene copolymer "BF-E", 67 parts by weight of the milled glass fiber (MGF) "EFH-7501" to obtain the resin composition.

### (Examples 6-8)

In each of Examples 6 to 8, a resin substrate having the circuit pattern for peel strength test was produced according to a substantially same method as Example 5 except for using a different epoxy-group containing ethylene copolymer from the epoxy-group containing ethylene copolymer "BF-E", as shown in Table 2.

With respect to each of Examples 5 to 8, the dielectric loss tangent (tan δ) and the 90 degree peel strength of the circuit pattern were measured. In addition, deflection temperature under load (DTUL) was measured under the load of 1.82 MPa according to ASTM D648. Results are shown in Table 2.

As understood from the results shown in Table 2, , the dielectric loss tangent of the resin substrate of each of Examples 5, 6 and 8, in which the epoxy-group containing ethylene copolymer having larger than 80 wt% of the ethylene unit in the molecule was used, is much lower than that of the resin substrate of Example 7, in which the epoxy-group containing ethylene copolymer having smaller than 80 wt% of the ethylene unit in the molecule was used. In addition, the resin substrate of each of Examples 5, 6 and 8 has a higher DTUL than the resin substrate of Example 7, while keeping good adhesion of the circuit pattern. Due to these reasons, it is preferred to use the epoxy-group containing ethylene copolymer containing larger than 80 wt% of the ethylene unit in the molecule.

**TABLE 2**

| | Examples | | | |
|---|---|---|---|---|
| | 5 | 6 | 7 | 8 |
| Liquid Crystalline Polyester | S 1 | S 1 | S 1 | S 1 |
| (parts by weight) | 100 | 100 | 100 | 100 |
| Epoxy-group containing | BF-E | BF-2C | BF-7M | BF-2B |
| Ethylene Copolymer | 15 | 15 | 15 | 15 |
| (parts by weight) | | | | |
| Inorganic Filler (MGF) | 67 | 67 | 67 | 67 |
| (parts by weight) | | | | |
| Heat Treatment Conditions | 300°C, | 300°C, | 300°C, | 300°C, |
| | 3hrs, N₂ | 3hrs, N₂ | 3hrs, N₂ | 3hrs, N₂ |
| Dielectric Loss tan δ (x 10⁻³) | 5.56 | 4.81 | 10.75 | 5.10 |
| Peel Strength (N/mm) | 0.40 | 0.41 | 0.40 | 0.38 |
| DTUL (°C) | 259.6 | 266.0 | 232.0 | 255.4 |

### (Example 9)

A resin substrate having the circuit pattern for peel strength test was produced according to a substantially same method as Example 1 except that 100 parts by weight of the liquid-crystalline polyester "S2" was mixed with 10 parts by weight of the epoxy-group containing ethylene copolymer "BF-E" and 200 parts by weight of the strontium titanate powder "ST-1" to obtain the resin composition.

### (Example 10)

A resin substrate having the circuit pattern for peel strength test was produced according to a substantially same method as Example 1 except that 100 parts by weight of the liquid-crystalline polyester "S1" was mixed with 10 parts by weight of the epoxy-group containing ethylene copolymer "BF-E" and 200 parts by weight of the strontium titanate powder "ST-1" to obtain the resin composition.

### (Comparative Example 4)

A resin substrate having the circuit pattern for peel strength test was produced according to a substantially same method as Example 9 except that the heat treatment was not performed.

### (Comparative Example 5)

A resin substrate having the circuit pattern for peel strength test was produced according to a substantially same method as Example 10 except that the heat treatment was not performed.

With respect to each of Examples 9,10 and Comparative Examples 4, 5, the dielectric loss tangent (tan δ) and the 90 degree peel strength of the circuit pattern were measured, as in the case of Example 1.

**TABLE 3**

| | Examples | | Comparative Examples | |
|---|---|---|---|---|
| | 9 | 10 | 4 | 5 |
| Liquid Crystalline Polyester | S2 | S1 | S2 | S 1 |
| (parts by weight) | 100 | 100 | 100 | 100 |
| Epoxy-group containing | BF-E | BF-E | BF-E | BF-E |
| Ethylene Copolymer | 10 | 10 | 10 | 10 |
| (parts by weight) | | | | |
| Inorganic Filler (ST-1) | 200 | 200 | 200 | 200 |
| (parts by weight) | | | | |
| Heat Treatment Conditions | 300°C, | 300°C, | None | None |
| | 3hrs, N₂ | 3hrs, N₂ | | |
| Dielectric Loss tan δ (x 10⁻³) | 4.74 | 7.17 | 5.41 | 7.30 |
| Peel Strength (N/mm) | 0.35 | 0.33 | 0.20 | 0.22 |

As understood from a comparison between Example 9 and Comparative Example 4 using the resin substrate having the same composition as Example 9, the dielectric loss tangent was remarkably reduced by the heat treatment. That is, the dielectric loss tangent of the heat-treated resin substrate of Example 9 corresponds to approximately 88 % of the dielectric loss tangent of the resin substrate of Comparative Example 4 without the heat treatment. Similarly, from the results of Example 10 and Comparative Example 5 using the resin substrate having the same composition as Example 10, the dielectric loss tangent of the heat-treated resin substrate of Example 10 corresponds to approximately 98 % of the dielectric loss tangent of the resin substrate of Comparative Example 5 without the heat treatment. In addition, these results show that the liquid-crystalline polyester "S2" is more preferable than the liquid-crystalline polyester "S1" from the viewpoint of further reducing the original dielectric loss tangent.

### (Examples 11 to 14)

In each of Examples 11 to 14, a resin substrate having the circuit pattern for peel strength test was produced according to a substantially same method as Example 1 except that 67 parts by weight of the milled glass fiber (MGF) "EFH-7501" was used as the inorganic filler in place of the barium titanate powder "NPO-S", and a heat treatment was performed to the resin substrate under the conditions shown in Table 4.

### (Comparative Example 6)

A resin substrate having the circuit pattern for peel strength test was produced according to a substantially same method as Example 11 except that the heat treatment was not performed.

### (Comparative Example 7)

A resin substrate having the circuit pattern for peel strength test was produced according to a substantially same method as Example 11 except that the epoxy-group containing ethylene copolymer was not used, and the heat treatment was not performed.

### (Comparative Example 8)

A resin substrate having the circuit pattern for peel strength test was produced according to a substantially same method as Example 11 except that the epoxy-group containing ethylene copolymer was not used, and the heat treatment was performed to the resin substrate under the conditions shown in Table 4.

With respect to each of Examples 11 to 14 and Comparative Examples 6 to 8, the dielectric loss tangent (tan δ), 90 degree peel strength of the circuit pattern, and the deflection temperature under load (DTUL) were measured, as in the case of the above-described Examples. In Comparative Example 8, only the peel strength and the dielectric loss tangent (tan δ) were measured. In addition, soldering heat resistance of the resin substrate was evaluated according to the following method. That is, after a sample of the resin substrate was dipped in a soldering bath for 60 seconds, the occurrence of deformation was checked. A minimum soldering bath temperature causing the deformation was determined as the heat resistance temperature. Results are shown in Table 4.

As understood from the results of Table 4, each of the resin substrates with the heat treatment of Examples 11 to 14 has a smaller dielectric loss tangent than the resin substrate of Comparative Example 6 without the heat treatment. For example, on the comparison between the results of Example 11 I and Comparative Example 6 using the resin substrate having the same composition as Example 11, the dielectric loss tangent was remarkably reduced by the heat treatment. That is, the dielectric loss tangent of the heat-treated resin substrate of Example 11 corresponds to approximately 76 % of the dielectric loss tangent of the resin substrate of Comparative Example 6 without the heat treatment. In addition, the soldering heat resistance and the DTUL were also improved by the heat treatment. Moreover, the results of Examples 11 to 14 show that there is a tendency that as the heat treatment temperature is higher, the dielectric loss tangent decreases, and the adhesion of the circuit pattern increases. On the other hand, the results of Comparative Examples 7 and 8 show that when the resin substrate does not contain the epoxy-group containing ethylene copolymer, there is a case that the dielectric loss tangent (tan δ) is increased by the heat treatment.

**TABLE 4**

| | Examples | | | | Comparative Examples | | |
|---|---|---|---|---|---|---|---|
| | 11 | 12 | 13 | 14 | 6 | 7 | 8 |
| Liquid Crystalline Polyester (parts by weight) | S1 | S1 | S1 | S1 | S1 | S1 | S1 |
| | 100 | 100 | 100 | 100 | 100 | 100 | 100 |
| Epoxy-group containing Ethylene Copolymer (parts by weight) | BF-E 10 | BF-E 10 | BF-E 10 | BF-E 10 | BF-E 10 | None | None |
| Inorganic Filler (MGF) (parts by weight) | 67 | 67 | 67 | 67 | 67 | 67 | 67 |
| Heat Treatment Conditions | 300°C, 3hrs, N₂ | 260°C, 3hrs, N₂ | 240°C, 3hrs, N₂ | 200°C, 3hrs, N₂ | None | None | 270°C, 3hrs, N₂ |
| Peel Strength (N/mm) | 0.53 | 0.49 | 0.45 | 0.43 | 0.42 | 0.29 | 0.26 |
| Dielectric Loss tan δ (x 10⁻³) | 5.13 | 5.22 | 5.46 | 6.00 | 6.73 | 5.18 | 5.48 |
| DTUL (°C) | >300 | 290 | 278 | 265.5 | 259.6 | 279.0 | --- |
| Soldering Heat Resistance (°C) | 330 | 310 | 310 | 310 | 300 | 310 | --- |

### Industrial Applicability

As shown in the above Examples, the present invention provides the resin molded article having a reduced dielectric loss tangent. In addition, when the heat treatment is performed to a substrate obtained by molding the liquid-crystalline polyester based resin composition described above, and then a metal film is coated on the substrate, it is possible to provide a circuit board having the improved adhesion and the improved heat resistance as well as the reduced dielectric loss tangent. Therefore, the resin molded article of the present invention having these advantages will be preferably used in the electric and electronics industry, and particularly in the technical field requiring high-frequency properties.

## Claims

1. A resin molded article obtainable by a heat treatment after being molded from a resin composition comprising a liquid-crystalline polyester and an epoxy-group containing ethylene copolymer at a temperature lower than a flow-beginning temperature of said liquid-crystalline polyester, wherein the resin molded article has a smaller dielectric loss tangent than the resin molded article obtained from the resin composition without the heat treatment,
wherein a content of said epoxy-group containing ethylene copolymer is in a range of 0.1 to 25 parts by weight with respect to 100 parts by weight of said liquid-crystalline polyester,
wherein said flow-beginning temperature of said liquid-crystralline polyester is defined as a temperature showing a melting viscosity of 4800 Pa.s (48000 poise) when a molten liquid-crystalline polyester is extruded through a nozzle under conditions of a load of 100 kgf/cm² (980 N/cm²) and a heating rate of 4°C/min by use of a capillary rheometer with the nozzle having an inner diameter of 1 mm and a length of 10 mm, and
wherein the heat treatment is performed at a temperature between a lower limit temperature calculated by subtracting 120°C from the flow-beginning temperature of said liquid-crystalline polyester and an upper limit temperature calculated by subtracting 20°C from the flow-beginning temperature.

2. The resin molded article as set forth in claim 1, wherein the dielectric loss tangent of the resin molded article is 90% or less of the dielectric loss tangent of the resin molded article obtained from the resin composition without the heat treatment.

3. The resin molded article as set forth in claim 1, wherein said epoxy-group containing ethylene copolymer contains 80 to 95 wt% of an ethylene unit and 5 to 15 wt% of at least one of an unsaturated-carboxylic acid glycidyl ester unit and an unsaturated glycidyl ether unit in the molecule thereof.

4. The resin molded article as set forth in claim 1, wherein said liquid-crystalline polyester contains 30 to 80 mol% of a repeating unit derived from 2-hydroxy-6-naphthoic acid, 10 to 35 mol% of a repeating unit derived from an aromatic diol, and 10 to 35 mol% of a repeating unit derived from an aromatic dicarboxylic acid.

5. The resin molded article as set forth in claim 1 having a metal film formed in a circuit pattern thereon.

6. A method of producing a resin molded article comprising the steps of:
molding a resin composition comprising a liquid-crystalline polyester and an epoxy-group containing ethylene copolymer; and
performing a heat treatment to a resultant molded article at a temperature lower than a flow-beginning temperature of said liquid-crystalline polyester, thereby obtaining the resin molded article having a smaller dielectric loss tangent than the resin molded article obtained from the resin composition without the heat treatment,
wherein a content of said epoxy-group containing ethylene copolymer is in a range of 0.1 to 25 parts by weight with respect to 100 parts by weight of said liquid-crystalline polyester,-wherein said flow-beginning temperature of said liquid-crystalline polyester is defined as a temperature showing a melting viscosity of 4800 Pa.s (48000 poise) when a molten liquid-crystalline polyester is extruded through a nozzle under conditions of a load of 100 kgf/cm² (980 N/cm²) and a heating rate of 4°C/min by use of a capillary rheometer with the nozzle having an inner diameter of 1 mm and a length of 10mm, and
wherein the heat treatment is performed at a temperature between a lower limit temperature calculated by subtracting 120°C from the flow-beginning temperature of said liquid-crystalline polyester and an upper limit temperature calculated by subtracting 20 °C from the flow-beginning temperature.

7. The method as set forth in claim 6, wherein said liquid-crystalline polyester is prepared by an ester-exchange and polycondensation reaction of at least one of an aromatic dicarboxylic acid and an aromatic hydroxycarboxylic acid, and an acylated compound prepared by acylating a phenolic hydroxyl group of at least one of an aromatic diol and an aromatic hydroxycarboxylic acid with a fatty acid anhydride.

8. The method as set forth in claim7, wherein the ester-exchange and polycondensation reaction is performed in the presence of an imidazole compound represented by the following chemical formula: 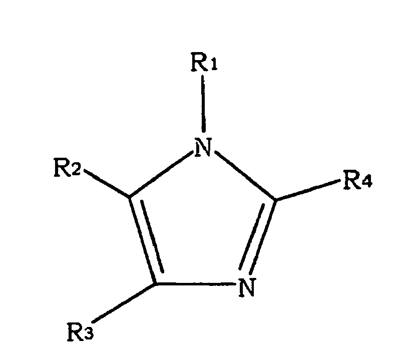 wherein, each of "R₁" to "R₄" is selected from hydrogen atom, alkyl group having a carbon number of 1 to 4, hydroxymethyl group, cyano group, cyanoalkyl group having a carbon number of 1 to 4, cyanoalkoxy group having a carbon number of 1 to 4, carboxyl group, amino group, aminoalkyl group having a carbon number of 1 to 4, aminoalkoxy group having a carbon number of 1 to 4, phenyl group, benzyl group, phenylpropyl group, and a formyl group.

## Patentansprüche

1. Harzformkörper, der, nachdem er aus einer Harzzusammensetzung geformt worden ist, welche einen flüssigkristallinen Polyester und ein Epoxygruppen enthaltendes Ethylen-Copolymer umfasst, durch eine Wärmebehandlung bei einer Temperatur erhalten werden kann, die niedriger ist als eine Fließbeginntemperatur des flüssigkristallinen Polyesters, wobei der Harzformkörper eine kleinere dielektrische Verlusttangente aufweist als der Harzformkörper, der ohne die Wärmebehandlung aus der Harzzusammensetzung erhalten wird,
wobei der Anteil des Epoxygruppen enthaltenden Ethylen-Copolymers im Bereich von 0,1 bis 25 Gewichtsteilen in Bezug auf 100 Gewichtsteile des flüssigkristallinen Polyesters liegt,
wobei die Fließbeginntemperatur des flüssigkristallinen Polyesters als eine Temperatur definiert ist, bei welcher eine Schmelzviskosität von 4.800 Pa·s (48.000 Poise) vorliegt, wenn ein geschmolzener flüssigkristalliner Polyester unter den Bedingungen eines Drucks von 100 kgf/cm² (980 N/cm²) und einer Aufheizgeschwindigkeit von 4 °C/min unter Verwendung eines Kapillarrheometers durch eine Düse extrudiert wird, wobei die Düse einen Innendurchmesser von 1 mm und eine Länge von 10 mm aufweist, und
wobei die Wärmebehandlung bei einer Temperatur zwischen einer unteren Grenztemperatur, die durch Subtrahieren von 120 °C von der Fließbeginntemperatur des flüssigkristallinen Polyesters berechnet wird, und einer oberen Grenztemperatur, die durch Subtrahieren von 20 °C von der Fließbeginntemperatur berechnet wird, durchgeführt wird.

2. Harzformkörper nach Anspruch 1, wobei die dielektrische Verlusttangente des Harzformkörpers 90 % oder weniger der dielektrischen Verlusttangente des Harzformkörpers beträgt, der ohne die Wärmebehandlung aus der Harzzusammensetzung erhalten wird.

3. Harzformkörper nach Anspruch 1, wobei das Epoxygruppen enthaltende Ethylen-Copolymer in dem Molekül 80 bis 95 Gew.-% Ethyleneinheiten und 5 bis 15 Gew.-% von mindestens einem aus einer Einheit eines Glycidylesters einer ungesättigten Carbonsäure und einer ungesättigten Glycidylether-Einheit enthält.

4. Harzformkörper nach Anspruch 1, wobei der flüssigkristalline Polyester 30 bis 80 Mol-% einer Wiederholungseinheit, die sich aus 2-Hydroxy-6-naphthoesäure ableitet, 10 bis 35 Mol-% einer Wiederholungseinheit, die sich aus einem aromatischen Diol ableitet, und 10 bis 35 Mol-% einer Wiederholungseinheit, die sich aus einer aromatischen Dicarbonsäure ableitet, enthält.

5. Harzformkörper nach Anspruch 1, welcher einen Metallfilm aufweist, der in einem Kreismuster darauf ausgebildet ist.

6. Verfahren zur Herstellung eines Harzformkörpers, welches die folgenden Schritte umfasst:
Formen einer Harzzusammensetzung, welche einen flüssigkristallinen Polyester und ein Epoxygruppen enthaltendes Ethylen-Copolymer umfasst; und
Durchführen einer Wärmebehandlung an einem resultierenden Formkörper bei einer Temperatur, die niedriger ist als eine Fließbeginntemperatur des flüssigkristallinen Polyesters, wodurch der Harzformkörper erhalten wird, der eine kleinere dielektrische Verlusttangente aufweist als der Harzformkörper, der ohne die Wärmebehandlung aus der Harzzusammensetzung erhalten wird,
wobei der Anteil des Epoxygruppen enthaltenden Ethylen-Copolymers im Bereich von 0,1 bis 25 Gewichtsteilen in Bezug auf 100 Gewichtsteile des flüssigkristallinen Polyesters liegt,
wobei die Fließbeginntemperatur des flüssigkristallinen Polyesters als eine Temperatur definiert ist, bei welcher eine Schmelzviskosität von 4.800 Pa·s (48.000 Poise) vorliegt, wenn ein geschmolzener flüssigkristalliner Polyester unter den Bedingungen eines Drucks von 100 kgf/cm² (980 N/cm²) und einer Aufheizgeschwindigkeit von 4 °C/min unter Verwendung eines Kapillarrheometers durch eine Düse extrudiert wird, wobei die Düse einen Innendurchmesser von 1 mm und eine Länge von 10 mm aufweist, und
wobei die Wärmebehandlung bei einer Temperatur zwischen einer unteren Grenztemperatur, die durch Subtrahieren von 120 °C von der Fließbeginntemperatur des flüssigkristallinen Polyesters berechnet wird, und einer oberen Grenztemperatur, die durch Subtrahieren von 20 °C von der Fließbeginntemperatur berechnet wird, durchgeführt wird.

7. Verfahren nach Anspruch 6, wobei der flüssigkristalline Polyester durch einen Esteraustausch und eine Polykondensationsreaktion einer aromatischen Dicarbonsäure und/oder einer aromatischen Hydroxycarbonsäure mit einer acylierten Verbindung hergestellt wird, die durch Acylieren einer phenolischen Hydroxylgruppe eines aromatischen Diols und/oder einer aromatischen Hydroxycarbonsäure mit einem Fettsäureanhydrid hergestellt wird.

8. Verfahren nach Anspruch 7, wobei der Esteraustausch und die Polykondensationsreaktion in Gegenwart einer Imidazolverbindung durchgeführt werden, welche die folgende chemische Formel aufweist: 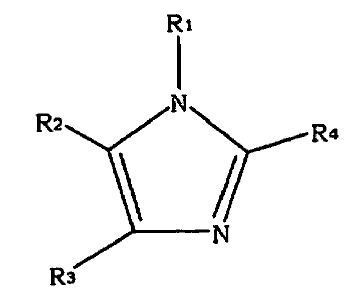 wobei R₁ bis R₄ jeweils aus einem Wasserstoffatom, einer Alkylgruppe mit 1 bis 4 Kohlenstoffen, einer Hydroxymethylgruppe, einer Cyanogruppe, einer Cyanoalkylgruppe mit 1 bis 4 Kohlenstoffatomen, einer Cyanoalkoxygruppe mit 1 bis 4 Kohlenstoffatomen, einer Carboxylgruppe, einer Aminogruppe, einer Aminoalkylgruppe mit 1 bis 4 Kohlenstoffatomen, einer Aminoalkoxygruppe mit 1 bis 4 Kohlenstoffatomen, einer Phenylgruppe, einer Benzylgruppe, einer Phenylpropylgruppe und einer Formylgruppe ausgewählt sind.

## Revendications

1. Article en résine moulé pouvant être obtenu par un traitement thermique après avoir été moulé à partir d'une composition de résine comprenant un polyester cristallin liquide et un copolymère d'éthylène contenant un groupe époxy à une température inférieure à une température de début d'écoulement dudit polyester cristallin liquide, dans lequel l'article en résine moulé a une tangente de pertes diélectriques plus petite que l'article en résine moulé obtenu à partir de la composition de résine sans le traitement thermique,
dans lequel une teneur dudit copolymère d'éthylène contenant un groupe époxy est dans une plage de 0,1 à 25 parties en poids pour 100 parties en poids dudit polyester cristallin liquide,
dans lequel ladite température de début d'écoulement dudit polyester cristallin liquide est définie comme une température montrant une viscosité à chaud de 4 800 Pa.s (48 000 poises) lorsqu'un polyester cristallin liquide fondu est extrudé à travers une buse sous des conditions d'une charge de 100 kgf/cm² (980 N/cm²) et d'une vitesse de chauffage de 4°C/min en utilisant un rhéomètre capillaire avec la buse ayant un diamètre intérieur de 1 mm et une longueur de 10 mm, et
dans lequel le traitement thermique est effectué à une température entre une température limite inférieure calculée en soustrayant 120°C de la température de début d'écoulement dudit polyester cristallin liquide et une température limite supérieure calculée en soustrayant 20°C de la température de début d'écoulement.

2. Article en résine moulé selon la revendication 1, dans lequel la tangente de pertes diélectriques de l'article en résine moulé est 90% ou moins de la tangente de pertes diélectriques de l'article en résine moulé obtenu à partir de la composition de résine sans le traitement thermique.

3. Article en résine moulé selon la revendication 1, dans lequel ledit copolymère d'éthylène contenant un groupe époxy contient 80 à 95% en poids d'une unité éthylène et 5 à 15% en poids d'au moins l'une d'une unité ester glycidylique d'acide carboxylique insaturée et d'une unité éther glycidylique insaturée dans la molécule de celui-ci.

4. Article en résine moulé selon la revendication 1, dans lequel ledit polyester cristallin liquide contient 30 à 80% en moles d'une unité répétitive dérivée de l'acide 2-hydroxy-6-naphtoïque, 10 à 35% en moles d'une unité répétitive dérivée d'un diol aromatique, et 10 à 35% en moles d'une unité répétitive dérivée d'un acide dicarboxylique aromatique.

5. Article en résine moulé selon la revendication 1 ayant un film métallique formé en un tracé de circuit sur celui-ci.

6. Procédé de production d'un article en résine moulé comprenant les étapes de :
moulage d'une composition de résine comprenant un polyester cristallin liquide et un copolymère d'éthylène contenant un groupe époxy ; et
exécution d'un traitement thermique sur un article moulé résultant à une température inférieure à une température de début d'écoulement dudit polyester cristallin liquide, obtenant ainsi l'article en résine moulé ayant une tangente de pertes diélectriques plus petite que l'article en résine moulé obtenu à partir de la composition de résine sans le traitement thermique,
dans lequel une teneur dudit copolymère d'éthylène contenant un groupe époxy est dans une plage de 0,1 à 25 parties en poids pour 100 parties en poids dudit polyester cristallin liquide,
dans lequel ladite température de début d'écoulement dudit polyester cristallin liquide est définie comme une température montrant une viscosité à chaud de 4 800 Pa.s (48 000 poises) lorsqu'un polyester cristallin liquide fondu est extrudé à travers une buse sous des conditions d'une charge de 100 kgf/cm² (980 N/cm²) et d'une vitesse de chauffage de 4°C/min en utilisant un rhéomètre capillaire avec la buse ayant un diamètre intérieur de 1 mm et une longueur de 10 mm, et
dans lequel le traitement thermique est effectué à une température entre une température limite inférieure calculée en soustrayant 120°C de la température de début d'écoulement dudit polyester cristallin liquide et une température limite supérieure calculée en soustrayant 20°C de la température de début d'écoulement.

7. Procédé selon la revendication 6, dans lequel ledit polyester cristallin liquide est préparé par une réaction de transestérification et de polycondensation d'au moins l'un d'un acide dicarboxylique aromatique et d'un acide hydroxycarboxylique aromatique, et d'un composé acylé préparé par acylation d'un groupe hydroxyle phénolique d'au moins l'un d'un diol aromatique et d'un acide hydroxycarboxylique aromatique avec un anhydride d'acide gras.

8. Procédé selon la revendication 7, dans lequel la réaction de transestérification et de polycondensation est effectuée en présence d'un composé imidazole représenté par la formule chimique suivante : 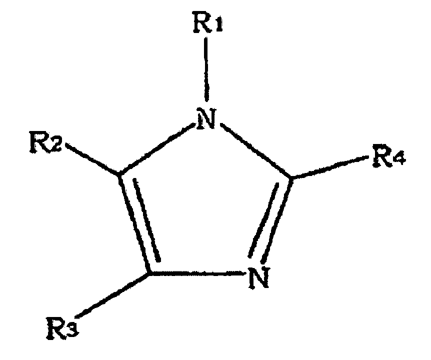 dans laquelle chacun de « R₁ » à « R₄ » est choisi parmi un atome d'hydrogène, un groupe alkyle ayant un nombre de carbones de 1 à 4, un groupe hydroxyméthyle, un groupe cyano, un groupe cyanoalkyle ayant un nombre de carbones de 1 à 4, un groupe cyanoalcoxy ayant un nombre de carbones de 1 à 4, un groupe carboxyle, un groupe amino, un groupe aminoalkyle ayant un nombre de carbones de 1 à 4, un groupe aminoalcoxy ayant un nombre de carbones de 1 à 4, un groupe phényle, un groupe benzyle, un groupe phénylpropyle, et un groupe formyle.
